**Europäisches Patentamt**

**European Patent Office**

**Office européen des brevets**

(19)

(11) Veröffentlichungsnummer : **0 025 036**
**B1**

(12) **EUROPÄISCHE PATENTSCHRIFT**

(45) Veröffentlichungstag der Patentschrift :
**18.01.84**

(21) Anmeldenummer : **80900263.7**

(22) Anmeldetag : **06.02.80**

(86) Internationale Anmeldenummer :
**PCT/AT 80/00007**

(87) Internationale Veröffentlichungsnummer :
**WO WO/80017 (21.08.80 Gazettee 80/19)**

(51) Int. Cl.³ : **G 03 F   9/00**, G 03 B  41/00,
**G 05 D   3/14**

(54) **VERFAHREN ZUR SCHARFEINSTELLUNG EINES MASKENBILDES AUF EIN WERKSTÜCK.**

(30) Priorität : **14.02.79 DE 2905635**

(43) Veröffentlichungstag der Anmeldung :
**18.03.81 Patentblatt 81/11**

(45) Bekanntmachung des Hinweises auf die Patenterteilung : **18.01.84 Patentblatt 84/03**

(84) Benannte Vertragsstaaten :
**CH FR GB NL SE**

(56) Entgegenhaltungen :
**DE-A- 2 246 384**
**DE-A- 2 707 477**
**DE-B- 2 427 323**
**US-A- 4 000 417**

(73) Patentinhaber : **CENSOR Patent- und Versuchs-Anstalt**
**Schlossstrasse 5**
**FL-9490 Vaduz (LI)**

(72) Erfinder : **Mayer,Herbert E.**
**Fallsgasse 486**
**FL-9492 Eschen (LI)**

(74) Vertreter : **Torggler, Paul, Dr. et al**
**Patentanwälte Dr. Paul Torggler Dr. Engelbert Hofinger Wilhelm-Greil-Strasse 16**
**A-6020 Innsbruck (AT)**

## Verfahren zur Scharfeinstellung eines Maskenbildes auf ein Werkstück

Die Erfindung betrifft ein Verfahren zur Scharfeinstellung eines Maskenbildes auf ein Werkstück beim Projektionskopieren der Maske auf das Werkstück, insbesondere auf ein Halbleitersubstrat zur Herstellung von integrierten Schaltungen, wobei über ein Projektionsobjektiv zumindest eine Ausrichtmarke der Maske auf das Werkstück abgebildet wird.

Charakteristik des bekannten Standes der Technik

Zum Projektionskopieren von Masken auf ein Halbleitersubstrat bei der Herstellung integrierter Schaltungen ist es üblich, Masken und Halbleitersubstrat vor der Abbildung von Schaltungsmustern relativ zueinander in der Bild- bzw. Objektebene auszurichten.

Hiezu ist es beispielsweise bekanntgeworden, der Maske ein aus einem transparenten Fenster bestehendes Ausrichtmuster und dem Halbleitersubstrat eine zugehörige Strichmarke zuzuordnen. Das Fenster und die Strichmarke werden über die Projektionsoptik ineinander abgebildet und mit Hilfe eines rotierenden Prismas von einer Auswerteeinrichtung abgetastet. Diese Auswerteeinrichtung mißt die Zeitabstände zwischen dem Eintreffen der Fensterkanten und der Strichmarke und gibt an Stellmotoren zur Verschiebung des Halbleitersubstrates Steuersignale aus, bis die Strichmarke in der Mitte des abgebildeten Fensters der Maske liegt.

Neben diesem Ausrichtvorgang in den XY-Koordinaten der Bild- bzw. Objektebene ist es bei optischen Kopiereinrichtungen auch notwendig, für eine exakte Fokussierung des optischen Systems zu sorgen, d. h. die im beschriebenen Anwendungsbeispiel einerseits durch die Maskenschicht und andererseits durch eine photoempfindliche Schicht auf der Substratoberfläche gegebenen Bild- und Objektflächen exakt in den Bild- und Objektebenen anzuordnen.

Für eine automatische Durchführung dieser sogenannten Z-Justierung ist es beispielsweise aus dem deutschen Patent 24 27 323 bekanntgeworden, in der Objekt- und/oder Bildebene einen fokussierten Strahl längs einer Kreisbahn zu bewegen und den Fokussierungszustand des Strahls automatisch zu überwachen. Beim Auftreten von Defokussierungen werden ortsabhängige Signale zur Korrektur von Ausrichtfehlern erzeugt. Nachteilig bei diesem Verfahren ist, daß zur Bestimmung und Korrektur von Fokussierungsfehlern ein getrennter Ausrichtvorgang sowie eine relativ aufwendige Apparatur notwendig ist.

Weiters ist es aus der DE-A1-26 33 297 bekanntgeworden, zur XY-Justierung verwendete Justiermarken auf dem Halbleitersubstrat auch für die Z-Justierung zu verwenden. Hiezu werden von den Justiermarken reflektierte Lichtstrahlen auf photoempfindliche Elemente gelenkt und das Projektionsobjektiv solange längs der optischen Achse verschoben, bis das von den photoempfindlichen Elementen empfangene, reflektierte Lichtminimal wird. Nachteilig dabei ist jedoch, daß für ein solches Verfahren nur relativ großflächige Justiermarken verwendbar sind und die erreichbare Genauigkeit oftmals unzureichend ist. Nachteilig ist vor allem, daß eine Verschiebung in Richtung der optischen Achse nicht nur zur Korrektur der Fokussierung, sondern schon zur Feststellung von deren Qualität notwendig ist.

Eine Abtastung des Bildes von Blutkörperchen normal zur Richtung der optischen Achse zur Feststellung des Fokussierzustandes des darauf gerichteten Mikroskops ist aus Fig. 4B der US-A-4 000 417 zu entnehmen. Die unmittelbare Übertragung des dort Gezeigten auf eine Einrichtung nach dem Stand der Technik, etwa gemäß DE-A1-2 707 477, ist jedoch nicht zweckmäßig. Bei einer solchen unmittelbaren Übertragung würde die Flankenneigung des Signals beurteilt, das durch die Justiermarken auf dem Werkstück erzeugt wird. Eine Justiermarke ist jedoch ein komplexes Gebilde, dessen Konfiguration zudem nicht einheitlich festgelegt ist. Die Schärfe der Abbildung der Justiermarke ist damit praktisch zur Fokussierung nur schlecht verwendbar.

Aufgabe der Erfindung

Aufgabe der Erfindung ist es, eine Beurteilung des Fokussierzustandes durch Abtasten des Intensitätsprofils von Marken in einer normal zur optischen Achse liegenden Ebene zu ermöglichen, da ein solches Abtasten ohnedies erfolgen muß, wenn das Werkstück mittels der darauf angebrachten Justiermarken normal zur optischen Achse justiert wird.

Darlegung des Wesens der Erfindung

Erfindungsgemäß wird hiezu vorgesehen, daß ein durch das Projektionsobjektiv rückprojiziertes Abbild des Bildes der in an sich bekannter Weise als von zwei parallelen Kanten begrenztes Fenster ausgebildeten Ausrichtmarke von einem zwischen Maske und Projektionsobjektiv angeordneten halbdurchlässigen Spiegel auf eine Auswerteeinrichtung geworfen wird und in einer Detektionsebene der Auswerteeinrichtung normal zu den Kanten des Fensters abgetastet wird, wobei proportional zum Intensitätsverlauf elektrische Signale erzeugt werden und die Steilheit der den Fensterkanten entsprechenden elektrischen Signale bestimmt wird, deren Wert zur Steuerung der relativen Position von Maske und Werkstück in Richtung der optischen Achse ausgewertet wird.

Bevorzugt ist vorgesehen, daß zumindest drei in der Maskenebene voneinander beabstandete Ausrichtmarken angeordnet werden und daß aus den Differenzen der genannten Steilheitssignale für jede der Ausrichtmarken gewonnene Signale zur Korrektur der Winkellage und ein aus dem Mittelwert der Steilheitssignale gewonnenes Signal zur Korrektur des Parallelabstandes von Maksenbildebene und Werkstückebene herangezogen werden. Auf diese Weise können Unebenheiten der Substratfläche ausgeglichen werden.

Nachfolgend wird die Erfindung anhand eines Ausführungsbeispieles und unter Bezugnahme auf die Zeichnungsfiguren näher erläutert.

Beschreibung der Zeichnungsfiguren

Die Figur 1 zeigt dabei in Schrägansicht die bekannte Anordnung der wesentlichsten Elemente einer Projektionskopiereinrichtung für die Herstellung integrierter Schaltungen,

Figur 1a das Schema eines Strahlenganges für eine Ausrichtmarke,

Figur 2 einen schematischen Ausschnitt aus Fig. 1a,

Figur 2a die Draufsicht auf die Detektionsebene,

Figur 3 das Intensitätsprofil einer Ausrichtmarke und

Figur 4 die Abbildungsschärfe einer Ausrichtmarke als Funktion der Defokussierung.

Beschreibung eines bevorzugten Ausführungsbeispiels

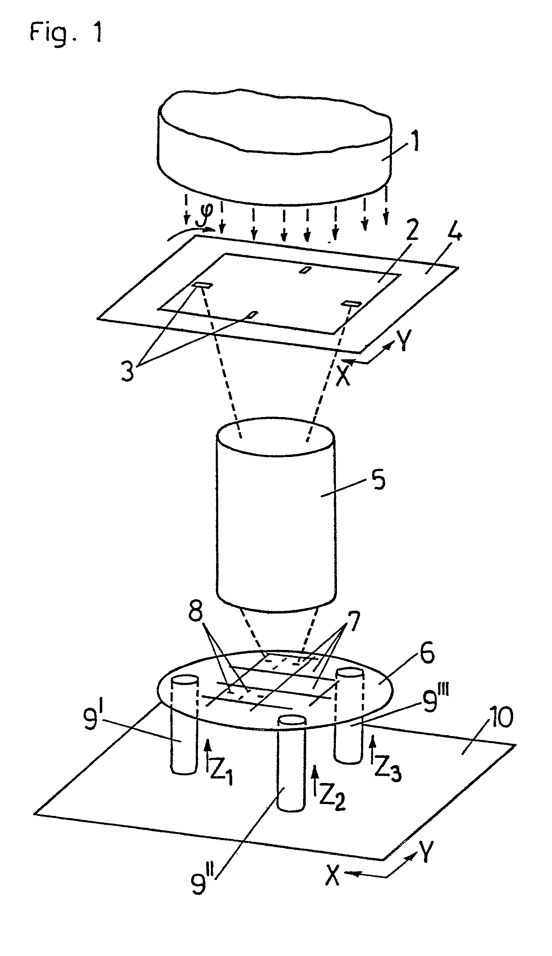

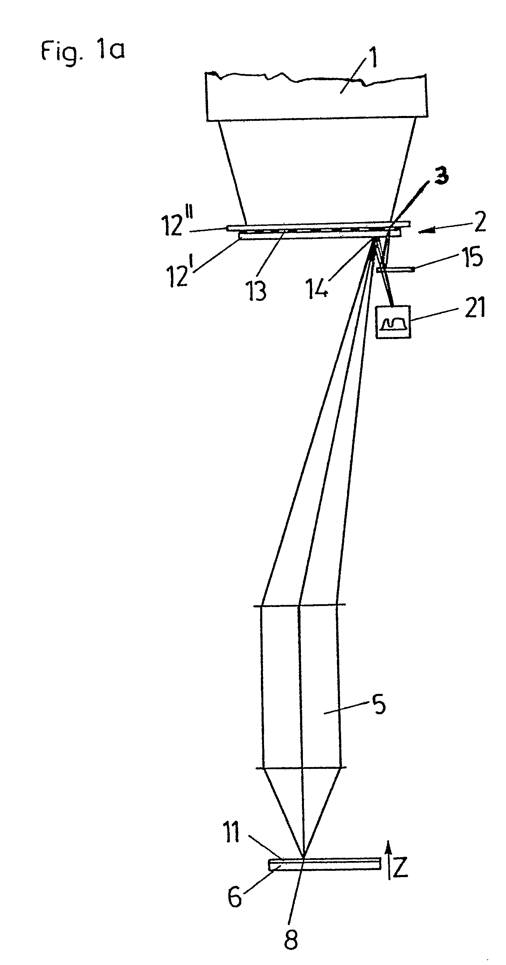

In Fig. 1 sind die wesentlichen Bestandteile einer Projektionskopiereinrichtung für die Herstellung integrierter Schaltungen dargestellt. Sie besteht im wesentlichen aus einer Belichtungseinrichtung 1, einer Maskenbühne 4, einem Projektionsobjektiv 5 und einem Koordinatentisch 10. Die abzubildende Maske 2 liegt auf der Maskenbühne 4 in der Objektebene des Projektionsobjektivs 5 auf, während das Halbleitersubstrat in der Bildebene auf drei Verschiebeeinrichtungen 9′ bis 9″ angeordnet ist.

Der Koordinatentisch 10 ist in bekannter Weise zur schrittweisen Verschiebung des Substrats 6 vorgesehen, um das Schaltungsmuster der Maske 2 in aufeinanderfolgenden Schritten auf vorbestimmten Bereichen 7 nach dem Step-and-Repeat-Verfahren abzubilden. Um vor jeder Abbildung eine exakte Ausrichtung zwischen Substrat 6 und Maske 2 relativ zur Projektionsoptik durchführen zu können, sind der Maske Ausrichtmuster 3 und den Bereichen 7 auf dem Substrat Justiermarken 8 zugeordnet. Zur Kompensation der jeweiligen Ausrichtfehler kann beispielsweise die Maskenbühne 4 in den Koordinaten der Objektebene, XY und φ, und das Substrat längs der optischen Achse des Systems verschoben werden. Um eine Ausrichtung des Substrats 6 auf die Bildebene des Projektionsobjektivs 5 durchführen zu können, sind drei getrennt steuerbare Verschiebeeinrichtungen 9′, 9″ und 9‴ vorgesehen.

Die Fig. 1a zeigt schematisch die für die Feststellung von Ausrichtfehlern notwendigen Einrichtungen. Die Maske 2 besteht dabei aus zwei Gläsern 12′ und 12″, zwischen welchen die Maskenschicht 13 angeordnet ist. Oberhalb der Maske 2 ist eine Belichtungseinrichtung 1 vorgesehen. Die von der Belichtungseinrichtung 1 auf eine als Fenster mit zumindest zwei parallelen Kanten ausgebildete Ausrichtmarke 3 fallenden Strahlen werden von einem unterhalb der Maske 2 angeordneten halbdurchlässigen Spiegel 15 reflektiert und über einen Spiegel 14, welcher an der Unterseite des Glases 12′ vorgesehen ist, auf den Bereich der zugehörigen Justiermarke 8 des Substrates 6 gelenkt. Das Abbild des Fensters 3 auf der Substratoberseite und die Justiermarke 8 werden von dem Projektionsobjektiv 5 rückprojiziert und von dem Spiegel 14 durch den halbdurchlässigen Spiegel 15 auf eine Auswerteeinrichtung 21 geworfen.

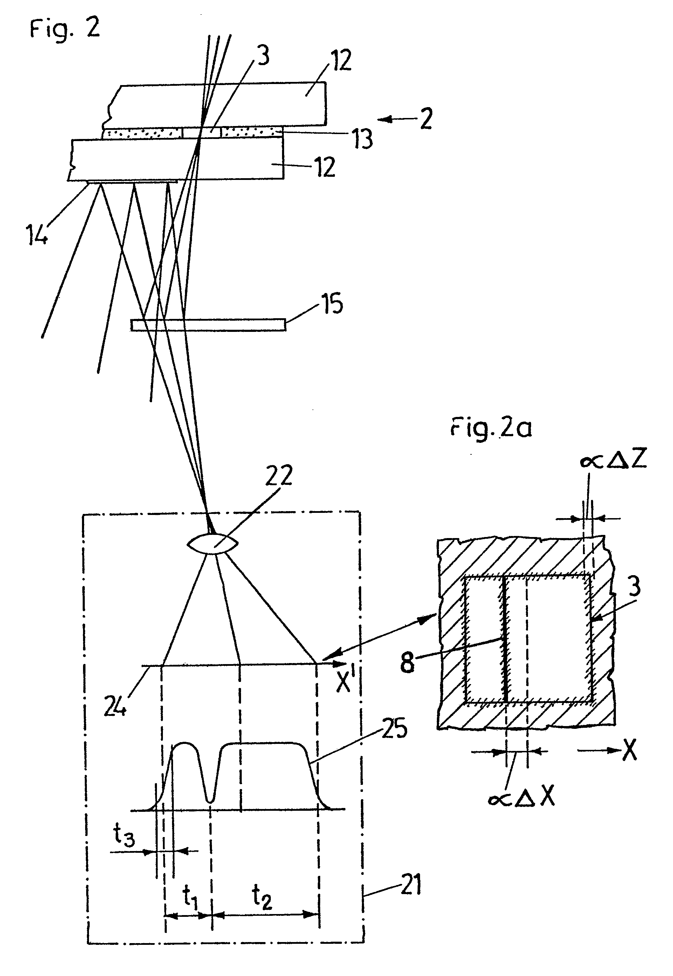

Fig. 2 zeigt einen Ausschnitt aus dem Strahlengang von Fig. 1a. Die Auswerteeinrichtung 22 lenkt das von dem Justiermarkenbereich auf dem Substrat kommende Strahlenbündel auf eine Detektionsebene 24. Die Justiermarke 8 ist im vorliegenden Fall, wie in Fig. 2a ersichtlich, als parallel zu zwei Kanten des Fensters 3 der Maske 2 verlaufendes Linienelement ausgebildet, welches in Sollage des Substrates 6 normal zu der Richtung verläuft, in welcher der Ausrichtfehler festgestellt werden soll. Das auf der Detektionsebene 24 entworfene Intensitätsprofil des Abbildes des Fensters 3 und der Justiermarke ist als Linie 25 dargestellt. Dieses Intensitätsprofil 25 wird in einer Richtung normal zum Linienelement 8 bzw. den entsprechenden Kanten des Fensters 3 abgetastet. Dies kann beispielsweise dadurch geschehen, daß ein nicht dargestelltes, rotierendes Prisma das Strahlenbündel auf ein nicht dargestelltes photoelektrisches Element wirft, vor dem ein parallel zum Linienelement 8 verlaufender Spalt angeordnet ist. Ebenso jedoch kann das photoelektrische Element die Detektionsebene 24 großflächig bilden, während ein Spalt vor der Detektionsebene 24 oszillierend verschoben wird. Entsprechend den auftretenden Intensitätswerten werden elektrische Signale erzeugt. Durch Messung der Zeitdifferenzen zwischen dem Durchlaufen bestimmter Schwellwerte wird der Ausrichtfehler normal zu den entsprechenden Kanten des Fensters 3 sowie der Fokussierfehler bestimmt. Ist die Zeit t1 zwischen dem Auftreten der ersten Fensterkante und dem Linienelement 8 gleich der Zeit t2 zwischen dem Auftreten des Linienelementes und der zweiten Fensterkante, so sind die Objekt- und Bilderflächen in ihren Ebenen in der entsprechenden Richtung exakt ausgerichtet. Die Ausrichtung der Objekt- bzw. Bildflächen in den Objekt- und Bildebenen des Projektionsobjektivs 5 längs der optischen Achse Z wird durch Messung der Steilheit des Abbildes der Fensterkanten bestimmt. Die Anstiegszeit t3 ist dabei wiederum proportional dem Fokussierungszustand.

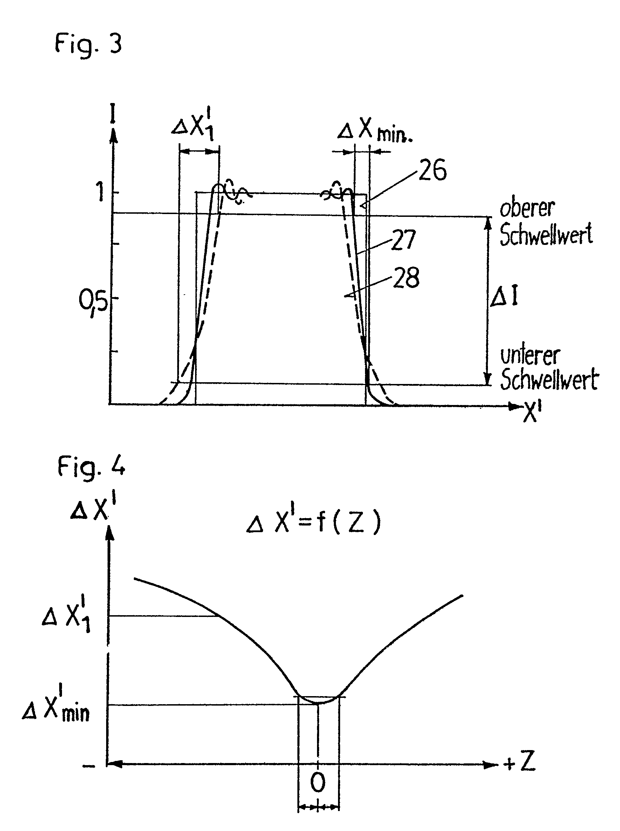

In Bild 3 ist das Intensitätsprofil des Abbildes des Fensters 3 auf der Detektionsebene 24 in der Richtung X′ dargestellt. Das theoretische, ideale Profil ist durch ein Rechteck 26 dargestellt, während real in fokussierter Lage der Bild- und Objektflächen das Profil 27 mit steilen Flanken gemessen wird. Befindet sich nun beispielsweise die Substratoberfläche in einem Abstand von der Bildebene, so werden die Kanten des Fensters 3 unscharf auf ihr abgebildet und auf der Detektionsebene zeigt sich ein Profil 28 mit Anstiegsflanken geringerer Steilheit. Durch Abtastung der Detektionsebene 24 in Richtung X′ werden dem Intensitätsverlauf entsprechende elektrische Signale erzeugt und die Zeitdifferenz zwischen dem Durchlaufen eines unteren und eines oberen Schwellwertes gemessen. Diese Zeitdifferenz ist von der Abbildungsschärfe des Fensters abhängig und daher ein Maß für die Defokussierung der Bildfläche. Die Bildfläche wird daher so lang in Richtung der optischen Achse verschoben, bis die steilsten Anstiegsflanken des Intensitätsprofils 27 erreicht werden. Die Fig. 4 zeigt dabei die Breite der Anstiegsflanken des Intensitätsprofils in Abhängigkeit von der Verschiebung der Substratoberfläche aus der Bildebene. Stimmt die Substratoberfläche mit der Bildfläche überein, so zeigt sich die kleinste Breite ΔX′, während bei Abweichungen der Substratoberfläche in positiver oder negativer Z-Richtung ein Ansteigen der Breite ΔX′ gegeben ist.

Sind zumindest drei Ausrichtmuster und zugehörige Justiermarken vorgesehen, so können auch Unebenheiten der Substratoberfläche ausgeglichen werden, indem die getrennten Verschiebeeinrichtungen Z1, Z2 und Z3 entsprechend angesteuert werden.

Ein besonderer Vorteil des erfindungsgemäßen Verfahrens liegt darin, daß die Feststellung der Justierfehler auch im Belichtungslicht, d. h. während der Abbildung von Schaltungsmustern, erfolgen kann. Damit ist die Überwachung des Fokussierungszustandes und gleichzeitige Korrektur möglich. Auch müssen keine eigenen Justiermarken bzw. keine eigenen Einrichtungen vorgesehen werden, da das Verfahren auch von den für die XY-Justierung vorgesehenen Mitteln durchgeführt werden kann. Die Richtung der Korrekturbewegung kann man beispielsweise durch zweimalige Messung des Fokussierungsfehlers mit einer dazwischenliegenden geringfügigen Verschiebung des Substrats 6 längs der optischen Achse festlegen. Ebenso ist es möglich, die Richtung aus einem Abbild des Linienelements zu bestimmen.

**Ansprüche**

1. Verfahren zur Scharfeinstellung eines Maskenbildes auf ein Werkstück beim Projektionskopieren der Maske auf das Werkstück, insbesondere auf ein Halbleitersubstrat zur Herstellung von integrierten Schaltungen, wobei über ein Projektionsobjektiv zumindest eine Ausrichtmarke der Maske auf das Werkstück abgebildet wird, dadurch gekennzeichnet, daß ein durch das Projektionsobjektiv rückprojiziertes Abbild des Bildes der in an sich bekannter Weise als von zwei parallelen Kanten begrenztes Fenster ausgebildeten Ausrichtmarke von einem zwischen Maske und Projektionsobjektiv angeordneten halbdurchlässigen Spiegel auf eine Auswerteeinrichtung geworfen wird und in einer Detektionsebene der Auswerteeinrichtung normal zu den Kanten des Fensters abgetastet wird, wobei proportional zum Intensitätsverlauf elektrische Signale erzeugt werden und die Steilheit der den Fensterkanten entsprechenden elektrischen Signale bestimmt wird, deren Wert zur Steuerung der relativen Position von Maske und Werkstück in Richtung der optischen Achse ausgewertet wird.

2. Verfahren nach Anspruch 1, dadurch gekennzeichnet, daß zumindest drei in der Maskenebene voneinander beabstandete Ausrichtmarken angeordnet werden und daß aus den Differenzen der genannten Steilheitssignale für jede der Ausrichtmarken gewonnene Signale zur Korrektur der Winkellage und ein aus dem Mittelwert der Steilheitssignale gewonnenes Signal zur Korrektur des Parallelabstandes von Maskenbildebene und Werkstückebene herangezogen werden.

**Claims**

1. Process for focusing a mask image onto a workpiece when projection copying the mask onto the workpiece, particularly onto a semiconductor substrate for the manufacture of integrated circuits, whereby at least one alignment mark of the mask is imaged onto the workpiece by a projection lens, characterized in that an image, which is retroprojected by the projection lens, of the image of the alignment mark designed in a manner known per se as a window limited by at least two parallel edges is cast upon an evaluating device by a semi-transparent mirror disposed between the mask and the projection lens and scanned in a detection plane of the evaluating device perpendicularly to the edges of the window, with generation of electrical signals proportional to the intensity profile and determination of the slope of the electrical signals corresponding to the window edges, the value thereof being evaluated for controlling the relative position of mask and workpiece in the direction of the optical axis.

2. Process according to claim 1, characterized in that at least three alignment marks are disposed spaced from one another in the mask plane and that signals obtained from the differences of said slope signals for each alignment mark are used for the correction of the angular position and a signal obtained from the mean value of the slope signals is used for the correction of the parallel distance between mask image plane and workpiece plane.

**Revendications**

1. Procédé de mise au point de l'image d'un masque sur une pièce à traiter lors de la reproduction par projection du masque sur la pièce à traiter, notamment sur un substrat semiconducteur pour la fabrication de circuits intégrés, l'image d'au moins une marque d'alignement du masque étant formée sur la pièce à traiter, par l'intermédiaire d'un objectif de projection, caractérisé en ce que la représentation, projetée en arrière par l'objectif de projection, de l'image de la marque d'alignement, réalisée de façon connue en soi sous la forme d'une fenêtre limitée par deux bords parallèles, est projetée par un miroir semi-transparent disposé entre le masque et l'objectif de projection, sur un dispositif d'exploitation et est explorée, dans un plan de détection du dispositif d'exploitation, perpendiculairement aux bords de la fenêtre, tandis que des signaux électriques sont produits proportionnellement à la variation de l'intensité et que se trouve réalisée une détermination de la pente des signaux électriques correspondant aux bords de la fenêtre et dont la valeur est exploitée pour la commande de la position relative du masque et de la pièce à traiter, suivant la direction de l'axe optique.

2. Procédé selon la revendication 1, caractérisé en ce qu'il est prévu au moins trois marques d'alignement distantes les unes des autres dans le plan du masque et que des signaux, obtenus à partir des différences des signaux connus de pente pour chacune des marques d'alignement, sont utilisés pour la correction de la position angulaire et qu'un signal, obtenu à partir de la valeur moyenne des signaux de pente, est utilisé pour la correction de l'écart de parallélisme entre le plan image du masque et le plan de la pièce à traiter.

Fig. 1

1

Fig. 1a

Fig. 2

Fig. 2a

Fig. 3

Fig. 4

$$\Delta X^I = f(Z)$$